# EUROPEAN PATENT APPLICATION

(11) **EP 1 679 812 A2**
(43) Date of publication of application: **12.07.2006**
(21) Application number: 05257108.0
(22) Date of filing: 17.11.2005
(51) Int. Cl.: H04H 1/00

(54) **Method of providing broadcast service and broadcasting receiver therefor**

(30) Priority: 07.01.2005 KR 2005001550
(71) Applicant: Samsung Electronics Co., Ltd., Suwon-si, Gyeonggi-Do (KR)
(72) Inventor: Seo, Ju-hee, 108-103 Nulpuren Byucksan Apt., Suwon-si Gyeonggi-do (KR); Park, Sung-il, Suwon-si Gyeonggi-do (KR)
(74) Representative: Brandon, Paul Laurence

(57) **Abstract**

A method and a broadcasting receiver that provide a broadcast service are provided. The method includes extracting and storing information on channels of at least one neighboring local transmitting station of a service provider adjacent to a current local transmitting station from a digital broadcast signal transmitted through a current channel from the current local transmitting station of the service provider; switching a tuning channel to another channel on the basis of the information on the channels of the at least one neighboring local transmitting station, when the channel for a current broadcast service changes from the current channel to the other channel; and decoding and outputting the same broadcast service as the current broadcast service among a plurality of broadcast services included in a digital broadcast signal transmitted through the other channel.

## Description

The present invention relates to broadcasting receivers, methods of providing a broadcasting service and computer-readable media for executing such methods.

Digital audio broadcasting (DAB) provides a variety of additional data services such as weather, traffic, entertainment, and images, as well as a high-quality audio service with a Compact Disc (CD) level sound quality by using sound coding methods that provide a high compression ratio. EUREKA-147 DAB, which is used in Europe, provides audio services with a CD level sound quality and a variety of additional data services by using a high-quality audio compression technology based on Moving Picture Experts Group (MPEG) audio layer II. Digital multimedia broadcasting (DMB) is a digital broadcasting standard which is more developed than DAB. DMB provides audio, video, and data broadcasting. DMB is classified into terrestrial DMB and satellite DMB, depending upon the transmission method. The DAB standard, such as EUREKA-147, is used for the audio broadcasting of DMB.

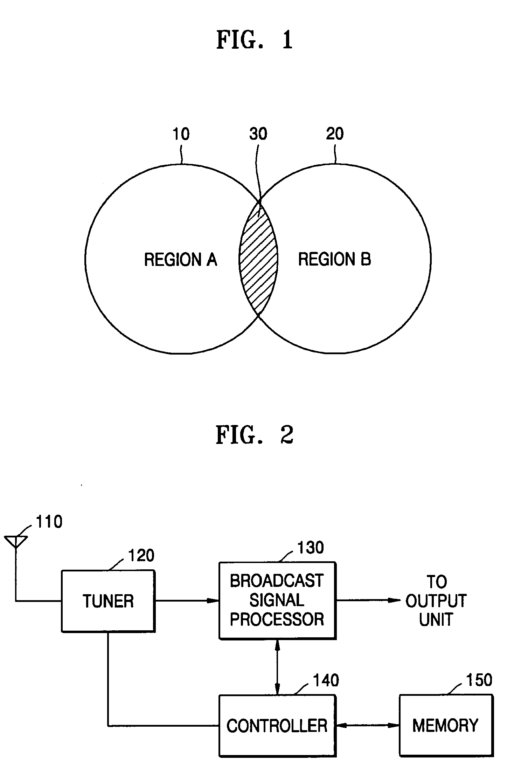

Conventionally, transmission channels of a broadcasting station use different frequencies by regional groups. Referring to FIG. 1, a specific broadcasting station transmits broadcast signals in Region A 10 using a transmission frequency f1 and transmits the broadcasting signals in Region B 20 using a transmission frequency f2. Region C 30 is a region where the broadcast signals with the frequency f1 and the broadcast signals with the frequency f2 are mixed. Therefore, when a user with a broadcasting receiver moves from Region A 10 to Region B 20, its frequency should be adjusted again so as to continuously receive the same broadcast service in Region B 20. When the broadcasting receiver is installed in a vehicle, the user may be required to manually manipulate the receiver to adjust frequencies during driving, thereby causing an unsafe driving condition. In addition, when the user does not know frequencies by regional groups of a specific broadcasting station, much time is required for searching for a desired frequency. Furthermore, in the case of digital broadcasting, such as DAB and DMB, the user must adjust the desired frequency and then select the broadcast service from a menu display in order to continuously receive the broadcast service in different regions, thereby causing inconvenience to the user.

Preferred embodiments of the present invention aim to provide a method of providing the same broadcast service as a broadcast service received by a user with a broadcasting receiver by automatically changing a channel without manually manipulating the broadcasting receiver even when the channel for the broadcast service received by the user is changed due to movement of the user with the broadcasting receiver.

Preferred embodiments of the present invention also aim to provide a broadcasting receiver for providing the same broadcast service as a broadcast service received by a user by automatically changing a channel without manually manipulating the broadcasting receiver even when the channel for the broadcast service received by the user is changed due to movement of the user.

According to an aspect of the present invention, there is provided a method of providing a broadcast service, the method comprising: extracting and storing channel information of at least one neighboring local transmitting station of a service provider adjacent to a current local transmitting station from a digital broadcast signal, which is transmitted through a current channel from the current local transmitting station of the service provider; switching a tuning channel to another channel based on the channel information of the at least one neighboring local transmitting station, if the channel of a current broadcast service changes from the current channel to the other channel; and decoding and outputting the same broadcast service as the current broadcast service among a plurality of broadcast services included in a digital broadcast signal transmitted through the other channel.

According to another aspect of the present invention, there is provided a method of providing a broadcast service, the method comprising: decoding and outputting a current broadcast service which is selected among a plurality of broadcast services included in a digital broadcast signal transmitted through a current channel from a current service provider; switching a tuning channel to another channel based on channel information by regional groups of service providers stored in advance, if the channel for the current broadcast service changes from the current channel to the other channel; and decoding and outputting a same broadcast service, which is identical to the current broadcast service, among a plurality of broadcast services included in a digital broadcast signal transmitted through the other channel.

According to another aspect of the present invention, there is provided a method of providing a broadcast service, the method comprising: decoding and outputting a current broadcast service which is selected among a plurality of broadcast services included in a digital broadcast signal transmitted through a current channel from a service provider; checking whether a channel of the current broadcast service changes from the current channel to another channel; transmitting a message requesting information on the other channel to the service provider, if the channel of the current broadcast service changes from the current channel to the other channel; switching a tuning channel to the other channel in accordance with the information on the other channel received from the service provider; and decoding and outputting a same broadcast service, which is identical to the current broadcast service, among a plurality of broadcast services included in a digital broadcast signal transmitted through the other channel.

According to another aspect of the present invention, there is provided a broadcasting receiver providing a broadcast service, the broadcasting receiver comprising: a tuner which outputs a digital broadcast signal transmitted through a current channel from a current local transmitting station of a service provider; a memory which stores channel information of at least one neighboring local transmitting station of the service provider adjacent to the current local transmitting station; a broadcast signal processor which decodes and outputs a current broadcast service which is selected among a plurality of broadcast services included in the digital broadcast signal; and a controller which switches a tuning channel of the tuner to another channel based on the channel information of the at least one neighboring local transmitting station stored in the memory and controlling the broadcast signal processor to decode and output a same broadcast service, which is identical to the current broadcast service, among a plurality of broadcast services included in a digital broadcast signal transmitted through the other channel, if a channel for the current broadcast service changes from the current channel to the other channel.

According to another aspect of the present invention, there is provided a broadcasting receiver providing a broadcast service, the broadcasting receiver comprising: a memory which stores channel information by regional groups of service providers; a tuner which outputs a digital broadcast signal transmitted through a current channel from a current service provider; a broadcast signal processor which decodes and outputs a current broadcast service which is selected among a plurality of broadcast services included in the digital broadcast signal; and a controller which switches a tuning channel of the tuner to another channel based on the channel information by regional groups of service providers stored in the memory and controlling the broadcast signal processor to decode and output a same broadcast service, which is identical to the current broadcast service, among a plurality of broadcast services included in a digital broadcast signal transmitted through the other channel, if a channel for the current broadcast service changes from the current channel to the other channel.

According to another aspect of the present invention, there is provided a broadcasting receiver providing a broadcast service, the broadcasting receiver comprising: a communication unit which executes bidirectional communication with a service provider; a tuner which outputs a digital broadcast signal transmitted through a current channel from the service provider; a broadcast signal processor which decodes and outputs a current broadcast service which is selected among a plurality of broadcast services included in the digital broadcast signal; and a controller which controls the communication unit to transmit a message which requests information on another channel to the service provider, switches a tuning channel of the tuner to the other channel in accordance with the information on the other channel received from the service provider and controls the broadcast signal processor to decode and output a same broadcast service, which is identical to the current broadcast service, among a plurality of broadcast services included in a digital broadcast signal transmitted through the other channel, if a channel for the current broadcast service changes from the current channel to the other channel.

Further features of the present invention are set out in the appended claims

The present invention will become more apparent by describing in detail exemplary embodiments thereof with reference to the attached drawings in which:

FIG. 1 is a diagram illustrating a conventional case where broadcast signals are transmitted using different frequencies by regional groups;

FIG. 2 is a block diagram illustrating a broadcasting receiver according to an exemplary embodiment of the present invention;

FIG. 3 is a block diagram illustrating an example of a broadcast signal processor shown in FIG. 2;

FIG 4 is a flowchart illustrating a method of providing a broadcast service according to an exemplary embodiment of the present invention;

FIG. 5 is a flowchart illustrating a method of providing a broadcast service according to another exemplary embodiment of the present invention;

FIG. 6 is a block diagram illustrating of a broadcasting receiver according to another exemplary embodiment of the present invention;

FIG. 7 is a flowchart illustrating a method of providing a broadcast service according to another exemplary embodiment of the present invention;

FIG. 8 is a diagram illustrating a structure of a DAB transmission frame according to an exemplary embodiment of the present invention; and

FIG. 9 is a diagram illustrating a multiplex structure of a DAB service according to an exemplary embodiment of the present invention.

Hereinafter, exemplary embodiments of the present invention will be described in detail with reference to the attached drawings. When elements in the drawings are denoted by reference numerals, the same elements are denoted by the same reference numerals.

FIG. 2 is a block diagram illustrating a broadcasting receiver according to an exemplary embodiment of the present invention. Referring to FIG. 2, the broadcasting receiver according to an exemplary embodiment of the present invention includes an antenna 110, a tuner 120, a broadcast signal processor 130, a controller 140, and a memory 150. The tuner 120 tunes one channel of a plurality of channels and outputs a digital broadcast signal of a plurality of digital broadcast signals received through the antenna 110.

The broadcast signal processor 130 receives and decodes the digital broadcast signal output from the tuner 120 and outputs the decoded digital broadcast signal to an output unit (not shown). The controller 140 controls the tuner 120, the broadcast signal processor 130, and the memory 150 to automatically provide the same broadcast service to a user.

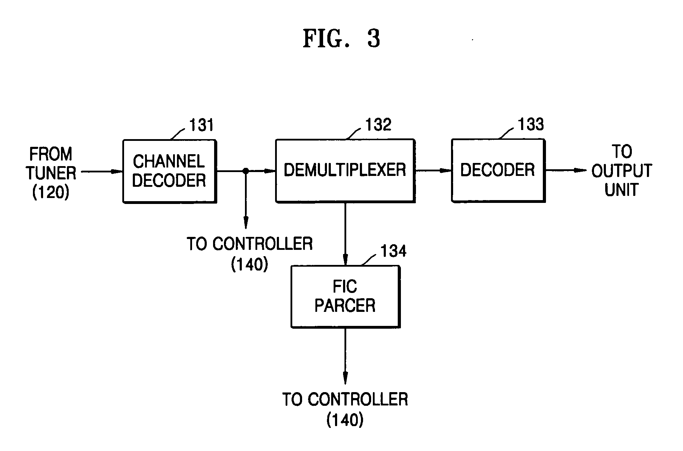

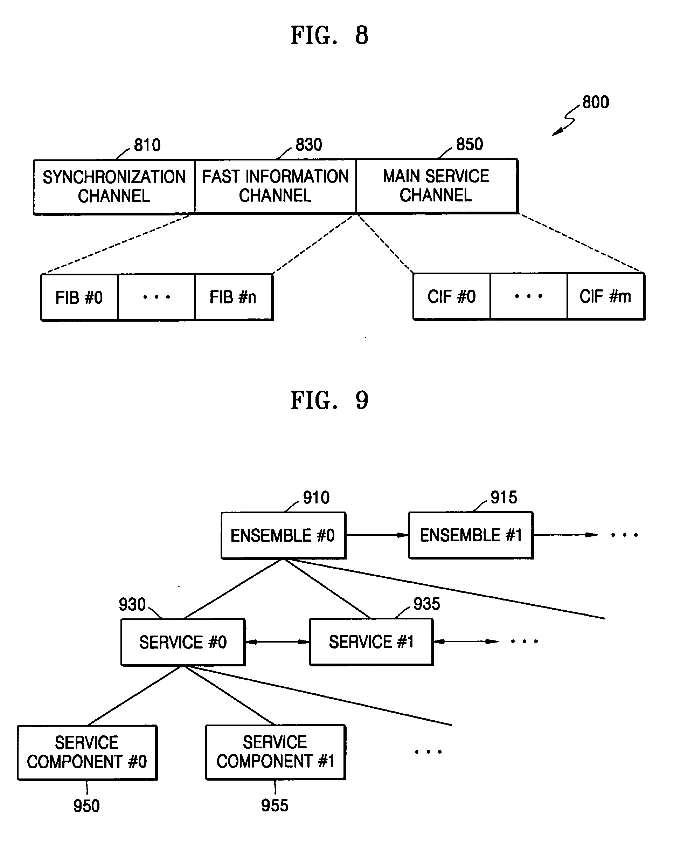

When the broadcasting receiver shown in FIG. 2 is a DAB receiver and the digital broadcast signal is a DAB signal, an example of the broadcasting receiver 130 shown in FIG. 2 is illustrated in FIG. 3. Referring to FIG. 3, the broadcast signal processor 130 includes a channel decoder 131, a demultiplexer 132, a decoder 133, and a fast information channel (FIC) parser 134. The channel decoder 131 performs the channel decoding according to a predetermined process. The demultiplexer 132 demultiplexes the channel-decoded signal and outputs a DAB transmission frame 800 shown in FIG. 8 to the decoder 133. The demultiplexer 132 extracts fast information channels (FIC) 830 from the DAB transmission frame 800 and outputs the extracted FIC 830 to the FIC parser 134. The FIC parser 134 parses FIC 830 and supplies information in the form of a fast information group (FIG), such as FIG 0/11 and FIG 0/21 to be described later, to the controller 140. The decoder 133 decodes the DAB transmission frame 800 and supplies the decoded signals to an output unit (not shown) such as a speaker. The decoder 133 can include a plurality of decoding means. That is, the decoder 133 can include a plurality of audio decoding means, video decoding means, and the like.

FIG. 8 is a diagram illustrating a structure of the DAB transmission frame 800 according to an exemplary embodiment of the present invention. Referring to FIG. 8, the DAB transmission frame 800 includes a synchronization channel (SC) 810, an FIC 830, and a main service channel (MSC) 850.

The SC 810 is composed of a null symbol for determining a transmission mode and a reference symbol for OFDM symbol synchronization and carrier frequency synchronization. The FIC 830 is a channel used for transmitting information for the receiver's processing data, for example, information on service construction, multiplex configuration, and the like, or for transmitting data necessary to fast transmit. The FIC 830 includes multiplex configuration information (MCI) containing information on structures of sub channels and service information (SI), which is additional information of the service and the like. Therefore, it can be seen from this channel what service data should be transmitted through the MSC and what application should use the service.

The FIC 830 includes a fast information data channel (FIDC) containing data to be fast transmitted within a given time. For example, simple messages for emergencies are contained in the FIDC. The FIC 830 is composed of a plurality of blocks called fast information blocks (FIB). Each FIB has a FIB data field and a CRC field. The FIB data field includes fast information groups (FIGs). In each FIG, a FIG type field, which indicates the format of data contained in the FIG data field, and a length field, which indicates the length of the FIG data field, are inserted in a header portion of the FIG, and actual data are added to the next portion of the FIG data field. For example, FIG 0/11 includes transmitter identification information (TII) and region identification information corresponding to TII, and FIG 0/21 includes the region identification information and frequency information corresponding to the region. The TII is information included in the MSC 850 that includes position information of the transmitting station. That is, the broadcasting receiver can find out the identification information of the local transmitting station that is sending out the broadcast signal and the transmission frequency of the local transmitting station from FIG 0/11 and FIG 0/21 included in the broadcast signal.

The MSC 850 transmits actual content data provided from the service provider. When the space of the FIC 830 is insufficient, a part of FIC data can be contained in the MSC 850. However, since the MSC 850 employs time interleaving, which may result in more or less delay time required for decoding, the MSC cannot contain FIC data to be fast transmitted. The data transmitting system can be classified into a stream mode and a packet mode. The MSC 850 includes a plurality of frames referred to as common interleaved frames (CIF).

FIG. 9 is a diagram illustrating a multiplex structure of a DAB service according to an exemplary embodiment of the present invention. Referring to FIG. 9, the multiplex structure of the DAB service according to an exemplary embodiment of the present invention has ensembles, services, and service components.

A plurality of encoded audio streams and a plurality of data are subjected to the channel coding and then are multiplexed into one bit stream along with system data, which is called an ensemble. Generally, one broadcasting station provides one ensemble. The service refers to the output that is selected by a user, such as a program service and a data service, and the service components refers to elements constituting a service. The service components of a given service are connected to each other by the multiplex configuration information. The service components are transmitted with the sub channels or the FIDC.

Referring again to FIG. 9, the DAB service according to an embodiment of the present embodiment includes at least two ensembles including ENSEMBLE #0 910 and ENSEMBLE #1 915. The ENSEMBLE #0 910 provides at least two services including SERVICE #0 930 and SERVICE #1 935. The SERVICE #0 930 has at least two service components including SERVICE COMPONENT #0 950 and SERVICE COMPONENT #1 955.

A method of providing a broadcast service according to an exemplary embodiment of the present invention will be described with reference to the structure of the broadcasting receiver shown in FIG. 2.

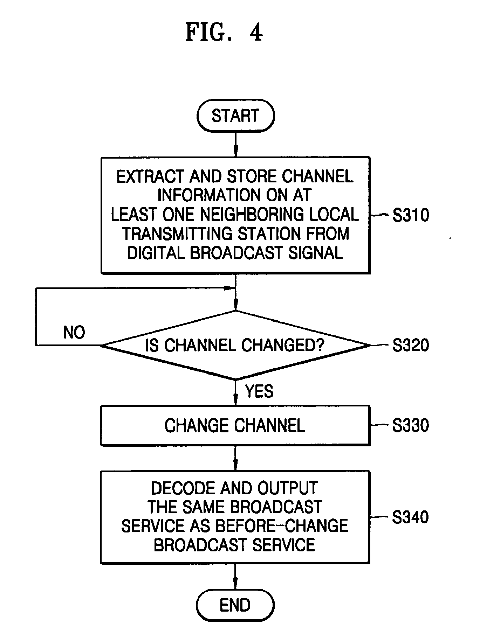

FIG. 4 is a flowchart illustrating the method of providing a broadcasting service according to an exemplary embodiment of the present invention.

The broadcasting receiver receives a digital broadcast signal transmitted through a current channel from a current local transmitting station of a service provider. A user selects one of a plurality of services provided by the received digital broadcast signal, and the selected service is then provided to the user. In the DAB broadcasting, a plurality of services such as a plurality of audio services, travel information services, and the like are provided through one channel. Further, the service provider may include other service providers in addition to a broadcasting station.

In the present exemplary embodiment, information on a channel of at least one neighboring local transmitting station of the service provider adjacent to the current local transmitting station is included in the digital broadcast signal transmitted through the current channel from the current local transmitting station. The MSC 850 of the DAB transmission frame 800 shown in FIG. 8 includes TII having position information of transmitting stations, and the FIC 830 includes FIG 0/11 and FIG 0/21. In the present exemplary embodiment, identification information of the neighboring local transmitting stations adjacent to the current local transmitting station is included in TII, and frequency information of the neighboring local transmitting stations is included in FIG 0/21. FIG 0/11 serves as a link for mutually linking TII and FIG 0/21 to each other. Therefore, the broadcasting receiver according to the present exemplary embodiment can determine channel information (i.e. identification information and frequency of the transmitting station) of at least one neighboring local transmitting station that is adjacent to the current local transmitting station from TII, FIG 0/11, and FIG 0/21, which are included in the current broadcast signal. Here, the current local transmitting station and the neighboring local transmitting station are local transmitting stations of same the service provider.

When the broadcast signal processor 130 extracts TII, FIG 0/11, and FIG 0/21 from the signal output from the tuner 120 and sends them to the controller 140, the controller 140 links and stores them in the memory 150. The information on the broadcast service currently received by the user is further stored in the memory 150. The information on the broadcast service is extracted from ensembles such as ENSEMBLE #0 910 and ENSEMBLE #1 915 in the multiplex structure of the DAB shown in FIG. 9.

The controller 140 of the broadcasting receiver checks whether the channel is changed (S320). The checking of whether the channel is changed at operation 320 is not limited to determining whether the channel is completely changed. As shown in FIG. 1, the checking of whether the channel is changed may also include the case that the broadcasting receiver is located in Region C 30, where the broadcast signal with the frequency f1 and the broadcast signal with the frequency f2 are mixed. Region C 30 is hereinafter referred to as a channel change region.

When at least one of intensity, SNR (Signal-To-Noise Ratio), and error rate of the broadcast signal transmitted through the current channel is equal to or less than a predetermined reference value for a predetermined time interval, the controller 140 determines that the broadcasting channel of the broadcast service is changed from the current channel to another channel. Alternatively, when the broadcast signal transmitted through the current channel decreases, a channel changing process to be described later may be performed. On the other hand, the intensity or the like of the broadcast signal is equal to or less than the predetermined reference value for a predetermined time interval may be utilized in order to distinguish the case where the broadcasting receiver is located in a tunnel or other region where reception cannot occur and the case where the broadcasting receiver is located in the channel change regions.

When determining that the channel for the current broadcast service is changed, the controller 140 changes the tuning channel of the tuner 120 on the basis of the information on the channels of the at least one neighboring local transmitting station stored in the memory 150 (S330). More specifically, the controller 140 tunes the tuner 120 among all the frequencies stored in the memory 150 and changes the channel to one frequency, which is selected in consideration of the intensity or the like of the output signal.

The controller 140 controls the broadcast signal processor 130 to decode and output the broadcast service that is matched with the information, which is stored in the memory 150, on the broadcast service received by the user through the previous channel (S340).

Now, a method of providing a broadcast service according to another exemplary embodiment of the present invention will be described.

The broadcasting receiver according to an exemplary embodiment of the present invention stores channel information by regional groups of service providers in the memory 150. The channel information may be transmitted through a broadcasting network, or the channel information may be provided from an external apparatus. In order to shorten the frequency tuning time, the channel information by regional groups of a specific service provider should have the structure that the channel information of a region adjacent to a specific region is positioned next to the channel information of the specific region.

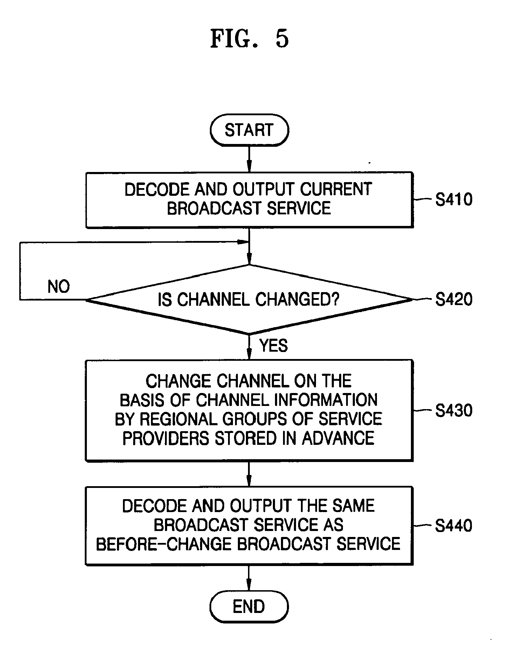

FIG. 5 is a flowchart illustrating a method of providing a broadcast service according to another exemplary embodiment of the present invention.

The current broadcast service selected from a plurality of services included in the digital broadcast signal, which is transmitted through the current channel by the current local transmitting station of the specific service provider, is decoded and output (S410).

The controller 140 checks whether the channel is changed (S420). The meaning and determination of the channel change are the same as in operation 320 shown in FIG. 4.

When it is determined that the channel for the current broadcast service is changed, the controller 140 changes the tuning channel of the tuner 120 on the basis of the channel information by regional groups of service providers stored in the memory 150. The controller 140 tunes the tuner 120 with the frequencies the local transmitting stations adjacent to the current local transmitting station by using the identification information of the current local transmitting station acquired in advance from TII included in the current broadcast signal, and changes the channel to one frequency thereof in consideration of the intensity or the like of the output signal.

The controller 140 controls the broadcast signal processor 130 to decode and output the broadcast service matched with the broadcast service received through the previous channel by the user, which is stored in the memory 150 (S440).

Now, an exemplary embodiment for acquiring changed channel information from a service provider using bidirectional communication will be described.

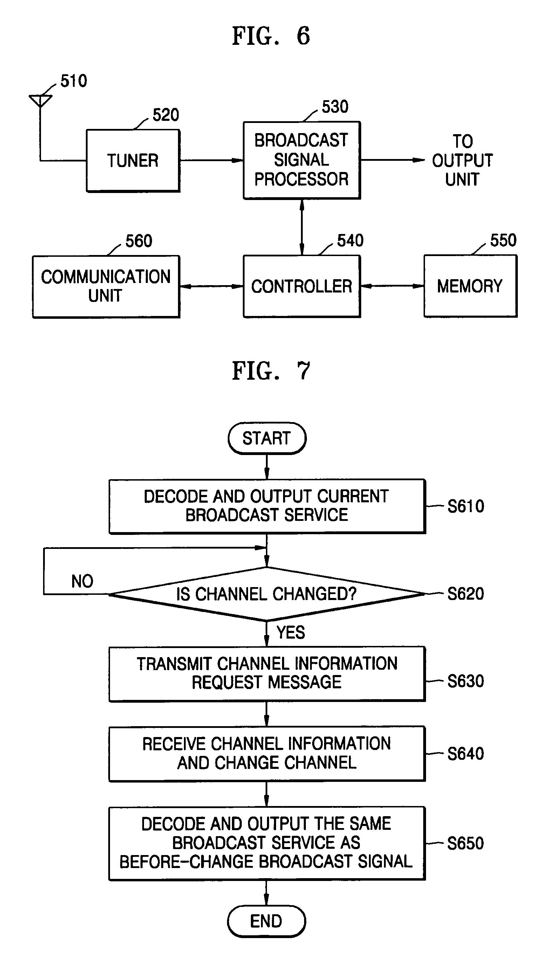

FIG. 6 is a block diagram illustrating a broadcasting receiver according to another exemplary embodiment of the present invention. Referring to FIG. 6, the broadcasting receiver according to another exemplary embodiment of the present invention includes an antenna 510, a tuner 520, a broadcast signal processor 530, a controller 540, a memory 550, and a communication unit 560. The communication unit 560 performs the bidirectional communication with service providers through a wireless communication network under the control of the controller 540.

On the basis of the structure of the broadcasting receiver shown in FIG. 6, a method of providing a broadcast service according to another exemplary embodiment of the present invention will be described with reference to FIG. 7.

A digital broadcast signal, which is transmitted through a current channel from a current local transmitting station of a specific service provider, is input to the broadcast signal processor 530 through the antenna 510 and the tuner 520. The broadcast signal processor 530 decodes and outputs a current broadcast service that is selected by a user among a plurality of services, which are included in the broadcast signal (S610).

The controller 540 of the broadcasting receiver checks whether a channel is changed (S620). The meaning and determination of the channel change are similar to operation 320 shown in FIG. 4.

When determining that the channel of the current broadcast service is changed, the controller 540 prepares a channel information request message and transmits the prepared channel information request message to the service provider, which provides the current broadcasting service, through the communication unit 630 (S630). The channel information request message includes current position information of the broadcasting receiver according to the present exemplary embodiment. In addition, the channel information request message may further include information on the current channel. The current position information of the broadcasting receiver can be acquired from a GPS device, which may be fitted to the broadcasting receiver, a broadcast signal relay, or TII included in the broadcast signal currently received.

The service provider receiving the channel information request message transmits to the broadcasting receiver information on channels through which broadcast services can be provided at the current position in accordance with the position information of the broadcasting receiver. The controller 540 of the broadcast receiver, which receives the channel information from the service provider, changes the tuning channel of the tuner 520 in accordance with the channel information (S640).

The broadcast signal received through the changed channel is input to the broadcast signal processor 530 through the antenna 510 and the tuner 520. The controller 540 controls the broadcast signal processor 530 to decode and output the broadcast service matched with the information, which is stored in the memory 550, on the broadcast service that was received through the previous channel (S650).

The invention can also be embodied as computer readable code stored on a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, optical data storage devices, and carrier waves (such as data transmission through the Internet). The computer readable recording medium can also be distributed over network coupled computer systems so that the computer readable code is stored and executed in a distributed fashion.

Up to now, aspects of the present invention have been shown and described with reference to the exemplary embodiments thereof. Although it has been exemplified in the exemplary embodiments of the present invention that the broadcast signals are DAB signals, the present invention is not limited to DAB signals. That is, the present invention can be applied to the case that the broadcast signals are DMB broadcast signals, which include DAB services. In addition, although Transport Experts Protocol Group (TPEG) has been exemplified in the exemplary embodiments of the present invention, the present invention is not limited to it. Furthermore, although traffic and traveling data and map data have been exemplified as the position-based service data, the present invention is not limited to it.

According to preferred embodiments of the present invention as described above, even when a channel for a broadcast service received by a user from a broadcasting is changed due to movement of the user with the broadcasting receiver, it is possible to provide the same broadcast service as the broadcast service previously received by the user by automatically changing the channel without requiring manual operation of the broadcasting receiver.

It will be understood by those of ordinary skill in the art that the present invention may be variously modified in forms and details without departing from the essential features of the present invention. The scope of the present invention is shown in the following claims, not in the above-mentioned description, and it should be understood that the present invention should include all the equivalents.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A broadcasting receiver which provides a broadcast service, the broadcasting receiver comprising:
a tuner (120, 520) which outputs a digital broadcast signal which is transmitted through a current channel from a current local transmitting station of a service provider;
a memory (150, 550) which stores channel information of at least one neighboring local transmitting station, which is adjacent to the current local transmitting station, of the service provider;
a broadcast signal processor (130, 530) which decodes and outputs a current broadcast service, which is selected among a plurality of broadcast services which are included in the digital broadcast signal; and
a controller (140, 540) which switches a tuning channel of the tuner to another channel based on the channel information of the at least one neighboring local transmitting station, which is stored in the memory, and controls the broadcast signal processor to decode and output a same broadcast service, which is identical to the current broadcast service, among a plurality of broadcast services which are included in a digital broadcast signal which is transmitted through the other channel, if a channel of the current broadcast service changes from the current channel to the other channel.

2. The broadcasting receiver according to claim 1, wherein the channel information of the at least one neighboring local transmitting station is extracted from the digital broadcast signal which is transmitted through the current channel.

3. The broadcasting receiver according to claim 1 or claim 2, wherein the controller (140, 540) determines the current channel of the current broadcast service changes from the current channel to the other channel if at least one of an intensity, a Signal-To-Noise Ratio (SNR), and an error rate of the digital broadcast signal which is transmitted through the current channel is equal to or less than a predetermined reference value.

4. The broadcasting receiver according to claim 3, wherein the controller (140, 540) determines the current channel of the current broadcast service changes from the current channel to the other channel if the at least one of the intensity, the SNR, and the error rate of the digital broadcast signal which is transmitted through the current channel is equal to or less than the predetermined reference value for a predetermined time interval.

5. A method of providing a broadcast service, the method comprising:
extracting and storing channel information of at least one neighboring local transmitting station of a service provider which is adjacent to a current local transmitting station from a digital broadcast signal which is transmitted through a current channel from the current local transmitting station of the service provider;
switching a tuning channel to another channel based on the channel information of the at least one neighboring local transmitting station, if the current channel of a current broadcast service changes from the current channel to the other channel; and
decoding and outputting a same broadcast service, which is identical to the current broadcast service, among a plurality of broadcast services which are included in a digital broadcast signal which is transmitted through the other channel.

6. The method according to claim 5, wherein the channel information of the at least one neighboring local transmitting station is extracted from the digital broadcast signal which is transmitted through the current channel.

7. The method according to claim 5 or claim 6, wherein the switching the tuning channel comprises
determining the channel of the current broadcast service changes from the current channel to the other channel if at least one of an intensity, a Signal-To-Noise Ratio (SNR), and an error rate of the digital broadcast signal which is transmitted through the current channel is equal to or less than a predetermined reference value.

8. The method according to claim 7, wherein in the determining, the channel of the current broadcast service is determined to be changed from the current channel to the other channel if the at least one of the intensity, the SNR, and the error rate of the digital broadcast signal which is transmitted through the current channel is equal to or less than a predetermined reference value for the predetermined time interval.

9. A broadcasting receiver which provides a broadcast service, the broadcasting receiver comprising:
a memory (150, 550) which stores channel information by regional groups of service providers;
a tuner (120, 520) which outputs a digital broadcast signal which is transmitted through a current channel from a current service provider;
a broadcast signal processor (130, 530) which decodes and outputs a current broadcast service which is selected among a plurality of broadcast services which are included in the digital broadcast signal; and
a controller (140, 540) which switches a tuning channel of the tuner to another channel based on the channel information by regional groups of service providers which is stored in the memory and controls the broadcast signal processor to decode and output a same broadcast service, which is identical to the current broadcast service, among a plurality of broadcast services which are included in a digital broadcast signal which is transmitted through the other channel, if a channel of the current broadcast service changes from the current channel to the other channel.

10. The broadcasting receiver according to claim 9, wherein the broadcast signal processor (130, 530) extracts information on a current region of the service provider from the digital broadcast signal which is transmitted through the current channel, and
wherein the controller receives the information on the current region from the broadcast signal processor and selects the other channel among the channels of the service provider which are broadcast in neighboring regions which are adjacent to the current region.

11. The broadcasting receiver according to claim 9 or claim 10, wherein the controller (140, 540) determines that the channel of the current broadcast service changes from the current channel to the other channel if at least one of an intensity, a Signal-To-Noise Ratio (SNR), and an error rate of the digital broadcast signal which are transmitted through the current channel is equal to or less than a predetermined reference value.

12. The broadcasting receiver according to claim 11, wherein the controller (140, 540) determines that the channel of the current broadcast service changes from the current channel to the other channel if the at least one of the intensity, the SNR, and the error rate of the digital broadcast signal which is transmitted through the current channel is equal to or less than the predetermined reference value for a predetermined time interval.

13. A method of providing a broadcast service, the method comprising:
decoding and outputting a current broadcast service which is selected among a plurality of broadcast services which are included in a digital broadcast signal which is transmitted through a current channel from a current service provider;
switching a tuning channel to another channel based on channel information by regional groups of service providers which is stored in advance, if the channel of the current broadcast service changes from the current channel to the other channel; and
decoding and outputting a same broadcast service, which is identical to the current broadcast service, among a plurality of broadcast services which are included in a digital broadcast signal which is transmitted through the other channel.

14. The method according to claim 13, further comprising extracting information on a current region of the service provider from the digital broadcast signal which is transmitted through the current channel,
wherein in the switching the tuning channel, the other channel is selected among the channels of the service provider in regions which are adjacent to the current region.

15. The method according to claim 13 or claim 14, wherein the switching the tuning channel comprises:
determining that the channel of the current broadcast service changes from the current channel to the other channel if at least one of an intensity, a Signal-To-Noise Ratio (SNR), and an error rate of the digital broadcast signal which are transmitted through the current channel is equal to or less than a predetermined reference value.

16. The method according to claim 15, wherein in the determining, the channel of the current broadcast service is determined to be changed from the current channel to the other channel if the at least one of the intensity, the SNR, and the error rate of the digital broadcast signal which is transmitted through the current channel is equal to or less than the predetermined reference value for a predetermined time interval.

17. A broadcasting receiver providing a broadcast service, the broadcasting receiver comprising:
a communication unit (560) which executes bidirectional communication with a service provider;
a tuner (520) which outputs a digital broadcast signal which is transmitted through a current channel from the service provider;
a broadcast signal processor (530) which decodes and outputs a current broadcast service which is selected among a plurality of broadcast services which are included in the digital broadcast signal; and
a controller (540) which controls the communication unit to transmit a message which requests information on another channel to the service provider, switches a tuning channel of the tuner to the other channel in accordance with the information on the other channel which is received from the service provider and controls the broadcast signal processor to decode and output a same broadcast service, which is identical to the current broadcast service, among a plurality of broadcast services which are included in a digital broadcast signal which is transmitted through the other channel, if a channel of the current broadcast service changes from the current channel to the other channel.

18. The broadcasting receiver according to claim 17, wherein the message includes information on a current location.

19. The broadcasting receiver according to claim 17 or claim 18, wherein the controller (540) determines that the channel of the current broadcast service changes from the current channel to the other channel if at least one of an intensity, a Signal-To-Noise Ratio (SNR), and an error rate of the digital broadcast signal which is transmitted through the current channel is equal to or less than a predetermined reference value.

20. The broadcasting receiver according to claim 19, wherein the controller (540) determines that the channel of the current broadcast service changes from the current channel to the other channel if the at least one of the intensity, the SNR, and the error rate of the digital broadcast signal which is transmitted through the current channel is equal to or less than the predetermined reference value for a predetermined time interval.

21. A method of providing a broadcast service, the method comprising:
decoding and outputting a current broadcast service which is selected among a plurality of broadcast services which are included in a digital broadcast signal which is transmitted through a current channel from a service provider;
checking whether a channel of the current broadcast service changes from the current channel to another channel;
transmitting a message which requests information on the other channel to the service provider, if the channel of the current broadcast service changes from the current channel to the other channel;
switching a tuning channel to the other channel in accordance with the information on the other channel which is received from the service provider; and
decoding and outputting a same broadcast service, which is identical to the current broadcast service, among a plurality of broadcast services which are included in a digital broadcast signal which is transmitted through the other channel.

22. The method according to claim 21, wherein the message includes information on a current location.

23. The method according to claim 21, wherein in the checking whether the channel of the current broadcast service changes the channel of the current broadcast service is determined to be changed from the current channel to the other channel if at least one of an intensity, a Signal-To-Noise Ratio (SNR), and an error rate of the digital broadcast signal which is transmitted through the current channel is equal to or less than a predetermined reference value.

24. The method according to claim 23, wherein in the checking whether the channel of the current broadcast service changes, the channel of the current broadcast service is determined to be changed from the current channel to the other channel if the at least one of the intensity, the SNR, and the error rate of the digital broadcast signal which is transmitted through the current channel is equal to or less than the predetermined reference value for a predetermined time interval.

25. A computer-readable medium having embodied thereon a computer program for a method of providing a broadcast service, the method comprising:
extracting and storing information on channels of at least one neighboring local transmitting station of a service provider which is adjacent to a current local transmitting station from a digital broadcast signal which is transmitted through a current channel from the current local transmitting station of the service provider;
switching a tuning channel to another channel on the basis of the information on the channels of the at least one neighboring local transmitting station, if the channel of a current broadcast service changes from the current channel to the other channel; and
decoding and outputting a same broadcast service, which is identical to the current broadcast service, among a plurality of broadcast services which are included in a digital broadcast signal which is transmitted through the other channel.

26. A computer-readable medium having embodied thereon a computer program for a method of providing a broadcast service, the method comprising:
decoding and outputting a current broadcast service which is selected among a plurality of broadcast services which are included in a digital broadcast signal which is transmitted through a current channel from a current service provider;
switching a tuning channel to another channel on the basis of channel information by regional groups of service providers which are stored in advance, if the channel of the current broadcast service changes from the current channel to the other channel; and
decoding and outputting a same broadcast service, which is identical to the current broadcast service, among a plurality of broadcast services which are included in a digital broadcast signal which is transmitted through the other channel.

27. A computer-readable medium having embodied thereon a computer program for a method of providing a broadcast service, the method comprising:
decoding and outputting a current broadcast service which is selected among a plurality of broadcast services which are included in a digital broadcast signal which is transmitted through a current channel from a service provider;
checking whether a channel of the current broadcast service changes from the current channel to another channel;
transmitting a message which requests information on the other channel to the service provider, if the channel of the current broadcast service changes from the current channel to the other channel;
switching a tuning channel to the other channel in accordance with the information on the other channel which is received from the service provider; and
decoding and outputting a same broadcast service, which is identical to the current broadcast service, among a plurality of broadcast services included in a digital broadcast signal which is transmitted through the other channel.
